# EUROPÄISCHE PATENTSCHRIFT

(11) **EP 0 769 816 B1**
(45) Veröffentlichungstag und Bekanntmachung des Hinweises auf die Patenterteilung: **08.11.2000**
(21) Anmeldenummer: 96113686.8
(22) Anmeldetag: 27.08.1996
(51) Int. Cl.: H01L 29/861, H01L 29/06, H01L 21/225, H01L 21/329

(54) **PM-Übergang mit hoher Durchbruchsspannung und Verfahren zur Herstellung**
High breakdown voltage PM junction and method for making it
Jonction PM à haute tension de claquage et procédé de fabrication

(30) Priorität: 19.10.1995 DE 19538853
(43) Veröffentlichungstag der Anmeldung: 23.04.1997
(73) Patentinhaber: ROBERT BOSCH GMBH, 70442 Stuttgart (DE)
(72) Erfinder: Goebel, Herbert, Dr.rer.nat., 72766 Reutlingen (DE); Goebel, Vesna, 72766 Reutlingen (DE)

(56) Entgegenhaltungen:
- EP-A- 0 311 816
- DE-A- 2 928 758
- FR-A- 2 707 041
- US-A- 5 286 660
- PATENT ABSTRACTS OF JAPAN vol. 10, no. 164 (E-410) [2220] , 11.Juni 1986 & JP-A-61 015376 (TOSHIBA K.K.), 23.Januar 1986,
- PATENT ABSTRACTS OF JAPAN vol. 4, no. 185 (E-38) [667] , 19.Dezember 1980 & JP-A-55 125670 (TOKYO SHIBAURA DENKI K.K.), 27.September 1980,
- PATENT ABSTRACTS OF JAPAN vol. 6, no. 176 (E-130) [1054] , 10.September 1982 & JP-A-57 093581 (NIPPON DENKI K.K.), 10.Juni 1982,

## Beschreibung

### Stand der Technik

Die Erfindung geht aus von einer Halbleiteranordnung und einem Verfahren zur Herstellung einer Halbleiteranordnung nach der Gattung der unabhängigen Patentansprüche. Aus der DE4320780A1 ist bereits eine Halbleiteranordnung und ein Verfahren zur Herstellung einer Halbleiteranordnung bekannt. Die Anordnung weist einen Siliciumchip mit einer N-dotierten Schicht und einer darauf angeordneten P-dotierten Schicht auf. Im Mittelbereich des Chips ist die N-dotierte Schicht stärker dotiert, so daß es dort zu einer verringerten Durchbruchspannung zwischen der P-dotierten Schicht und der N-dotierten Schicht kommt. Es wird so eine Halbleiterdiode geschaffen, bei der ein Durchbruch bevorzugt im Mittelbereich stattfindet. Für das erfindungsgemäße Verfahren wird auf einer schwach N-dotierten Schicht eine stärker N-dotierte Schicht aufgebracht. Durch Einbringen von Sägegräben die durch die stärker N-dotierte Schicht hindurchgreifen wird die stärker N-dotierte Schicht in einzelnen Bereichen entfernt. Bei der nachfolgenden Erzeugung der P-dotierten Schicht und anschließendes Zerteilen im Bereich der eingesägten Gräben wird sichergestellt, daß in den Randbereichen kein PN-Übergang zwischen der P-dotierten Schicht und der stärker N-dotierten Schicht gelegen ist.

Aus der EP 0 311 816 A1 ist es bekannt, bei einem zweischichtigen Bauelement eine erste Schicht vorzusehen, in der eine zweite Schicht derart eingebettet wird, daß sie im Randbereich tiefer in die erste Schicht eindringt als im Mittelbereich des Bauelements.

In der DE 2 928 758 A1 ist eine Schutzringstruktur vorgesehen, die eine Zone niedriger Dotierung und hoher Eindringtiefe aufweist.

Die US 5 286 660 beschreibt ein Verfahren zur Dotierung eines Halbleiterwafers, bei der ein tiefes Eindringen von Dotieratomen in der Mitte der herzustellenden Bauelemente ermöglicht wird durch Einbringen von Punktdefekten mittels Ionenimplantation.

### Vorteile der Erfindung

Die erfindungsgemäße Halbleiteranordnung mit den kennzeichnenden Merkmalen des unabhängigen Patentanspruchs hat dem gegenüber den Vorteil einer einfacheren Herstellbarkeit bei Verwendung einer homogen dotierten ersten Schicht. Die so geschaffenen Halbleiterbauelemente weisen einen gut sperrenden PN-Übergang auf, dessen Durchbruchseigenschaft gut eingestellt werden können, da durch den kleineren Gradienten der Dotierstoffkonzentration im Randbereich ein Durchbruch des PN-Übergangs nicht im Randbereich erfolgt. Die Durchbruchseigenschaften des PN-Übergangs können daher mit einfachen Mitteln besonders gut kontrolliert werden. Weiterhin kann aufgrund der homogenen Dotierung eine relativ große Dotierstoffkonzentration für die erste Schicht verwendet werden. Die erste Schicht weist daher einen besonders geringen Widerstand auf. Das Herstellungsverfahren für eine Halbleiteranordnung nach dem unabhängigen Patentanspruch hat den Vorteil, daß vergleichsweise wenig Prozeßschritte zur Herstellung der Halbleiteranordnung erforderlich sind. Weiterhin läßt sich dieses Verfahren aber weitgehend außerhalb eines Reinraumes durchführen, was die Herstellungskosten verringert. Durch die in den abhängigen Ansprüchen aufgeführten Maßnahmen sind vorteilhafte Weiterbildungen und Verbesserungen der Halbleiteranordnung bzw. des Verfahrens zur Herstellung einer Halbleiteranordnung nach den unabhängigen Patentansprüchen möglich. Durch das Einbrennen einer starken Dotierung in die Unterseite der ersten Schicht kann der Widerstand der ersten Schicht weiter verringert werden. Die Kristall-Schädigungen werden besonders einfach durch Sägen eingebracht. Es bilden sich dann Ausnehmungen im Randbereich der Halbleiteranordnungen aus.

### Zeichnungen

Ausführungsbeispiele der Erfindung sind in den Zeichnungen dargestellt und in der nachfolgenden Beschreibung näher erläutert. Es zeichnen die Figuren 1 und 2 ein erfindung gemäßes Herstellungsverfahren und die Figuren 3-4 ein Verfahren zur Herstellung der erfindungsgemäßen Halbleiteranordnungen.

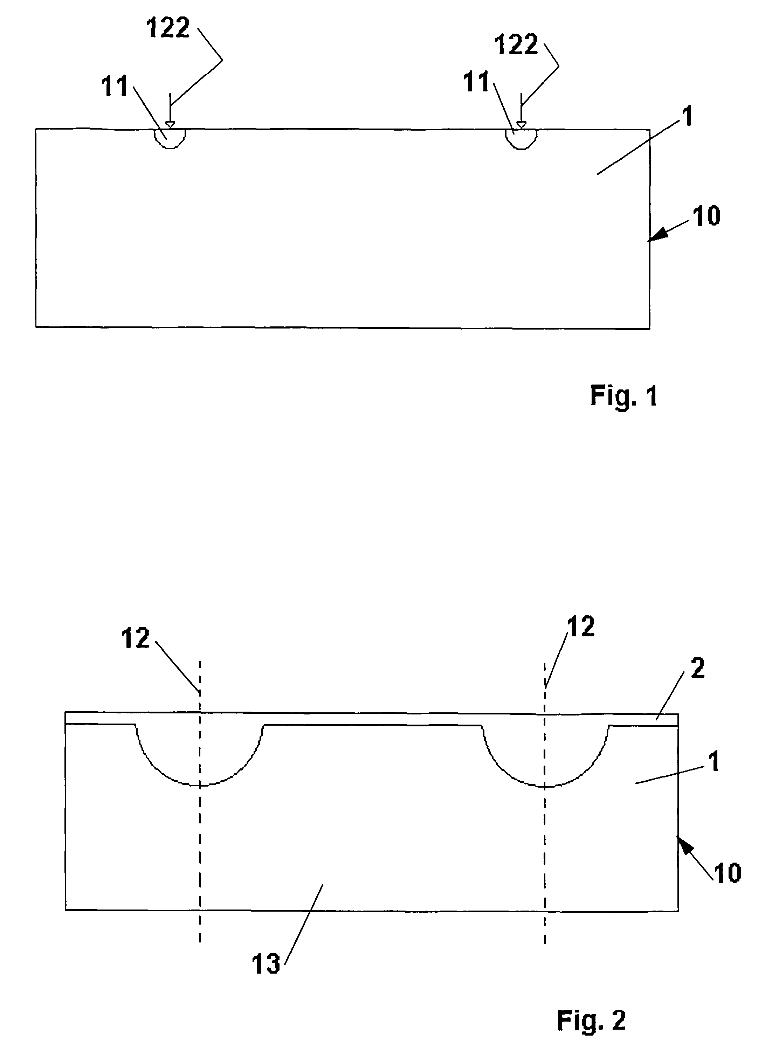

In der Figur 1 wird ein einkristallines Halbleitersubstrat 10 gezeigt, welches aus einer ersten Siliciumschicht 1 besteht. In die Oberseite dieser ersten Siliciumschicht 1 werden Kristallschäden 11 eingebracht. Bei diesen Kristallschäden 11 handelt es sich um Bereiche der ersten Siliciumschicht 1 in denen die einkristalline Kristallstruktur gestört wird. Derartige Kristallschädigungen 11 können bspw. durch mechanische Einwirkungen wie Ritzen, Sägen oder dem Aufsetzen von Ultraschallwerkzeugen eingebracht werden. Weiterhin sind eine Vielzahl von Strahlen geeignet um Kristallschädigungen zu erzeugen. Bspw. können dazu Röntgenstrahlen oder Elektronenstrahlen herangezogen werden. Eine andere Möglichkeit der Kristallschädigung ist das Implantieren von Ionen, bspw. Argonionen. Die Einwirkung, die die Kristallschädigung 11 in der Siliciumschicht 1 erzeugt wird durch die Pfeile 122 verdeutlicht. Weiterhin sind natürlich auch alle anderen Prozesse verwendbar, die geeignete Kristallschädigungen in der Oberfläche der ersten Siliciumschicht 1 erzeugen.

In einem weiteren Schritt, der in Figur 2 gezeigt wird, wird dann durch einen Diffusionsschritt in die erste Siliciumschicht 1 eine zweite Siliciumschicht 2 eingebracht, die von entgengengesetztem Leitungstyp ist. Für die weitere Beschreibung wird davon ausgegangen, daß die erste Siliciumschicht 1 vom N-Typ und die zweite Siliciumschicht 2 vom P-Typ ist. Für die Diffusion wird auf der Oberseite der ersten Siliciumschicht 1 ein Dotierstoff aufgebracht, der dann bei erhöhten Temperaturen durch einen Diffusionsprozeß in die erste Siliciumschicht 1 eindringt und so eine P-Dotierung erzeugt. In den einkristallienen Bereichen der Siliciumschicht 1 erfolgt dieser Diffusionsprozeß mit einer geringeren Geschwindigkeit als in den Bereichen 11 in denen Kristallstörungen vorliegen. Die Figur 2 zeigt einen Querschnitt durch das Halbleitersubstrat 10 nach dem erfolgten Diffusionsschritt. Wie zu erkennen ist, ist der P-Dotierungsstoff in den Bereichen, in denen vor dem Diffusionsschritt die Kristallschädigungen 11 vorlagen, der P-Dotierstoff wesentlich weiter in die erste Halbleiterschicht eingedrungen. Da auf der Oberfläche der Schicht 1 für alle Bereiche die gleiche Dotierstoffkonzentration vorlag, folgt daraus, daß die gleiche Menge Dotierstoff auf ein wesentlich größeres Volumen verteilt ist, d.h. der Dotierstoffgradient wesentlich geringer ist als in den Bereichen in denen die Diffusion im einkristallienen Silicium erfolgt.

Die Diffusion erfolgt bei höheren Temperaturen, bspw. 1200°C, bei denen auch eine Heilung von Kristallschäden bewirkt wird. Um zu erreichen, daß die Kristallschäden zu einem möglichst geringen Gradienten im Randbereich führen, sollte der Diffusionsprozeß daher so erfolgen, daß eine Diffusion in die Tiefe vor der Ausheilung der Kristallschäden erreicht wird. Dies läßt sich dadurch erreichen, daß der Diffusionsprozeß möglichst kurz ist, d.h. durch eine hohe Dotierstoffkonzentration auf der Oberfläche und hohe Diffusionstemperaturen.

Für die weitere Verarbeitung wird das Halbleitersubstrat 10 durch einbringen von Schnitten, entlang von Zerteilungslinien 12 in einzelne Siliciumplättchen 13 zerteilt. Die Kristallschädigungen 11 wurden dabei vollständig entlang der Zerteilungslinien 12 ausgebildet, so daß die Randbereiche der Siliciumplättchen 13 vollständig von einem Bereich gebildet werden, in dem die P-Diffusion weiter in die erste Schicht eingedrungen ist als im Mittelbereich.

Durch die erste Schicht 1 und die zweite Schicht 2 wird ein PN-Übergang geschaffen. Wenn dieser PN-Übergang in Sperrichtung gepolt wird, so erfolgt beim Überschreiten einer bestimmten Spannung ein Durchbruch des PN-Überganges. Problematisch ist dabei, wenn der PN-Übergang im Randbereich auftritt, da sich in diesem Bereich durch Anlagerungen von Verschmutzungen oder Oberflächeneffekten kein exakter Spannungswert für den Durchbruch einstellen läßt. Weiterhin ist aufgrund der genannten Effekte die Durchbruchsspannung im Randbereich in der Regel geringer als im Mittelbereich. Es muß daher sichergestellt werden, daß der Durchbruch des PN-Überganges nicht im Randbereich sondern im Mittelbereich erfolgt. In der DE4320780 wurde dies dadurch erreicht, daß der Mittelbereich stärker dotiert wurde als der Randbereich, so daß die Durchbruchspannung im Mittelbereich geringer ist als im Randbereich. In der vorliegenden Erfindung wird die Durchbruchspannung des PN-Bereiches im Randbereich dadurch erhöht, daß der Gradient der Dotierstoffkonzentration, d.h. die Änderung der Dotierstoffkonzentration der zweiten Schicht 2 im Randbereich geringer ist als im Mittelbereich. Es hat sich nämlich gezeigt, daß die Durchbruchsspannung eines PN-Überganges auch vom Grandienten beeinflußt wird und um so größer wird, je geringer der Gradient ist. Es wird so auf einfache Weise sichergestellt, daß ein Durchbruch des PN-Überganges nur im Mittelbereich und nicht im Randbereich des Halbleiterplättchens erfolgen kann.

Der so gezeigte Aufbau kann vorteilhafterweise als Diode, insbesondere Zehnerdiode verwendet werden. Es sind jedoch auch alle anderen Bauteile denkbar, die einen PN-Übergang aufweisen.

Das in den Figuren 1 und 2 beschriebene Verfahren weist weiterhin den Vorteil auf, daß die Prozeßierungder Halbleiterelemente nicht in einem Reinraum erfolgen muß. Sowohl das Einbringen der Kristallschädigungen 11 sowie auch der Diffusionsschritt können außerhalb eines Reinraumes durchgeführt werden. Das erfindungsgemäße Verfahren ist daher besonders kostensparend.

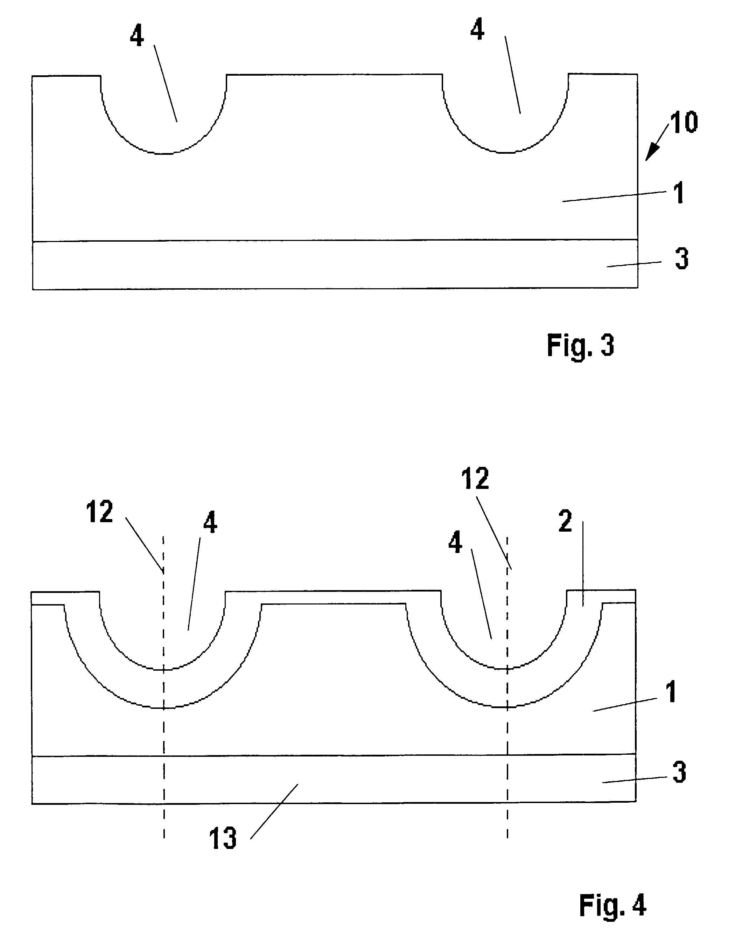

In den Figuren 3-4 wird ein zweites Ausführungsbeispiel des erfindungsgemäßen Verfahrens gezeigt. Dabei wird in der Figur 3 ein Querschnitt durch ein Halbleitersubstrat gezeigt, welches eine erste Siliciumschicht aufweist. In die Unterseite ist eine stark dotierte Schicht 3 eingebracht, die die gleiche Leitfähigkeit aufweist wie die Siliciumschicht 1. in die Oberseite der Siliciumschicht 1 sind durch eine mechanische Bearbeitung Gräben 4 eingebracht. Die Gräben 4 können bspw. durch sägen, fräsen, schleifen oder ein ähnliches Verfahren eingebracht werden. Im Umfeld der Gräben 4 ist die Kristallstruktur der ersten Siliciumschicht 1 gestört. Um diesen Effekt besonders stark auszubilden wird ein Sägeblatt oder ein Fräswerkzeug verwendet, welches eine besonders rauhe Körnigkeit der in der Regel für die Bearbeitung für Silicium verwendeten Diamantpartikel aufweist. Es wird so erreicht, daß im Umfeld der Gräben 4 besonders viele Störungen in das Kristallgitter der ersten Siliciumschicht 1 eingebracht sind.

In der Figur 4 wird die so gebildete Struktur nach einem Diffusionsschritt gezeigt. In die Oberseite der Siliciumschicht 1 ist ein Dotierstoff eingebracht, der einen Leitungstyp bildet, der entgegengesetzt zum Leitungstyp der ersten Schicht 1 ist. Für die weitere Beschreibung soll davon ausgegangen werden, daß die erste Schicht 1 zum N-Leitungstyp und die durch Diffusion gebildete zweite Schicht 2 vom P-Leitungstyp ist. Im Bereich der Gräben 4 weist somit die P-Schicht einen wesentlich gerigeren Gradienten auf als im Mittelbereich. Es wird so wiederum sichergestellt, daß ein Durchbruch des PN-Überganges zwischen der ersten Schicht 1 und der zweiten Schicht 2 ausschließlich im Mittelbereich des Halbleiterplättchens, welches durch Zerteilen des Substrats 10 entlang der Zerteilungslinien 12 gebildet wir, erfolgt.

Die in den Figuren 3-4 gezeigte Rückseitenaufdotierung 3 dient zu einer weiteren Verringerung des Widerstandes einer so gebildeten Diode. Bei ausreichend hoher Dotierung der ersten Schicht 1 kann auch auf die Schicht 3 verzichtet werden.

Vor dem Zerteilen der in den Figuren 2 und 4 gezeigten Halbleiteranordnung kann jeweils noch auf der Ober- und Unterseite eine Metallisierung angebracht werden. Ein derartiges Bauelement ist dann unmittelbar nach dem Zerteilen als Zehnerdiode verwendbar wobei auf der Ober- und Unterseite jeweils noch Anschlußdrähte für eine Kontaktierung der Diode vorgesehen werden.

## Patentansprüche

1. Halbleiteranordnung mit einem Halbleiterplättchen (13) mit einem Randbereich und einem Mittelbereich, wobei das Halbleiterplättchen (13) eine erste Schicht (1) eines ersten Dotierungstyps aufweist, wobei in die erste Schicht (1) eine zweite Schicht (2) eingebracht ist, wobei die zweite Schicht (2) vom entgegengesetzten Dotierungstyp wie die erste Schicht (1) ist und mit der zweiten Schicht (2) einen PN-Übergang bildet, in der ersten Schicht (1) die Dotierstoffkonzentration im wesentlichen gleichmäßig ist und der Gradient der Dotierstoffkonzentration der zweiten Schicht (2) in einer zur Oberseite des Halbleiterplättchens senkrechten Richtung (122) im Randbereich geringer ist als im Mittelbereich, dadurch gekennzeichnet, daß im Randbereich des Halbleiterplättchens (13) ausgehend von der Oberseite eine Ausnehmung eingebracht ist, so daß infolge der durch das Einbringen der Ausnehmung induzierten Kristallschäden die zweite Schicht im Randbereich tiefer in die erste Schicht eingedrungen ist als im Mittelbereich.

2. Halbleiteranordnung nach Anspruch 1, dadurch gekennzeichnet, daß die zweite Schicht (2) auf der Oberseite der ersten Schicht (1) eingebracht ist, und daß auf der Unterseite der ersten Schicht (1) eine stark dotierte Schicht (3) des gleichen Dotierungstyps wie die erste Schicht (1) eingebracht ist.

3. Halbleiteranordnung nach einem der vorhergehenden Ansprüche, dadurch gekennzeichnet, daß auf der Oberseite und Unterseite des Halbleiterpättchens (13) eine metallische Schicht aufgebracht ist.

4. Verfahren zur Herstellung einer Halbleiteranordnung, bei dem in ein Halbleitersubstrat (10) mit einer ersten Schicht (1) eines ersten Dotierungstyps eine zweite Schicht (2) eines zweiten Dotierungstyps durch Belegen einer Oberfläche des Halbleitersubstrats (10) mit einem Dotierstoff und nachfolgender Diffusion eingebracht wird, wobei die erste Schicht (1) und die zweite Schicht (2) einen PN-Übergang bilden und wobei das Halbleitersubstrat (10) durch Schnitte in Halbleiterplättchen (13) zerteilt wird, dadurch gekennzeichnet, daß in Bereichen, die nach der Zerteilung Randbereiche der Halbleiterplättchen (13) bilden, vor dem Diffusionsschritt in der ersten Schicht (1) Kristallschäden (11) eingebracht werden, so daß die Diffusion in den beschädigten Bereichen (11) schneller erfolgt als in den nicht geschädigten Bereichen.

5. Verfahren nach Anspruch 4, dadurch gekennzeichnet, daß die Kristallschäden durch mechanische Bearbeitung, Implantation von Fremdkörperpartikeln oder Bestrahlen eingebracht werden.

6. Verfahren nach Anspruch 4 oder 5, dadurch gekennzeichnet, daß die erste Siliciumschicht (1) eine im wesentlichen gleichmäßige Dotierstoffkonzentration aufweist.

## Claims

1. Semiconductor arrangement having a semiconductor chip (13) having an edge region and a central region, the semiconductor chip (13) having a first layer (1) of a first doping type, a second layer (2) being introduced into the first layer (1), the second layer (2) being of the opposite doping type to the first layer (1) and forming a PN junction with the second layer (2), the dopant concentration in the first layer (1) being essentially uniform and the gradient of the dopant concentration of the second layer (2) in a direction (122) perpendicular to the top side of the semiconductor chip being lower in the edge region than in the central region, characterized in that a recess is introduced in the edge region of the semiconductor chip (13), proceeding from the top side, with the result that, on account of the crystal damage induced by the introduction of the recess, the second layer has penetrated into the first layer more deeply in the edge region than in the central region.

2. Semiconductor arrangement according to Claim 1, characterized in that the second layer (2) is introduced on the top side of the first layer (1) and in that a heavily doped layer (3) of the same doping type as the first layer (1) is introduced on the underside of the first layer (1).

3. Semiconductor arrangement according to one of the preceding claims, characterized in that a metallic layer is applied on the top side and underside of the semiconductor chip (13).

4. Method for fabricating a semiconductor arrangement, in which there is introduced into a semiconductor substrate (10) having a first layer (1) of a first doping type a second layer (2) of a second doping type by deposition of a dopant on a surface of the semiconductor substrate (10) and subsequent diffusion, the first layer (1) and the second layer (2) forming a PN junction and the semiconductor substrate (10) being divided into semiconductor chips (13) by cuts, characterized in that, in regions which form edge regions of the semiconductor chips (13) after the division process, crystal damage (11) is introduced prior to the diffusion step in the first layer (1), with the result that the diffusion takes place more rapidly in the damaged regions (11) than in the undamaged regions.

5. Method according to Claim 4, characterized in that the crystal damage is introduced by mechanical processing, implantation of impurity particles or irradiation.

6. Method according to Claim 4 or 5, characterized in that the first silicon layer (1) has an essentially uniform dopant concentration.

## Revendications

1. Dispositif semi-conducteur comprenant une plaquette semi-conductrice (13) avec une zone marginale et une zone intermédiaire,
• la plaque semi-conductrice (13) ayant une première couche (1) d'un premier type de dopage,
• la première couche (1) recevant une seconde couche (2),
• la seconde couche (2) ayant un type de dopage opposé à celui de la première couche (1) et formant avec la seconde couche (2) une jonction PN, la première couche (1) ayant une concentration en dopant essentiellement régulière, et le gradient de la concentration en dopant de la seconde couche (2) étant plus faible dans la zone marginale, dans une direction (122) perpendiculaire à la face supérieure de la plaquette semi-conductrice, que dans la zone intermédiaire,
caractérisé en ce que
dans la zone marginale de la plaquette semi-conductrice (13), en partant de la face supérieure, on a un creux de sorte que du fait des accidents du cristal induits par la réalisation du creux, la seconde couche pénètre plus profondément dans la première couche dans la zone marginale que dans la zone intermédiaire.

2. Dispositif semi-conducteur selon la revendication 1,
caractérisé en ce que
• la seconde couche (2) est réalisée sur la face supérieure de la première couche (1) et
• sur la face inférieure de la première couche (1) on a une couche (3) à plus fort dopage, de même type de dopant que la première couche (1).

3. Dispositif semi-conducteur selon l'une des revendications précédentes,
caractérisé par
une couche métallique réalisée sur la face supérieure et la face inférieure de la plaquette semi-conductrice (13).

4. Procédé de fabrication d'un dispositif semi-conducteur,
selon lequel
• dans un substrat semi-conducteur (10), muni d'une première couche (1) d'un premier type de dopant, on réalise une seconde couche (2) d'un second type de dopant en mettant à la surface du substrat semi-conducteur (10) un dopant, puis en effectuant une diffusion,
• la première couche (1) et la seconde couche (2) formant une jonction (PN) et
• le substrat semi-conducteur (10) étant divisé en plaquettes semi-conductrices (13) par découpe,
caractérisé en ce que
dans les zones qui, après découpe, forment les zones marginales des plaquettes semi-conductrices (13), avant l'étape de diffusion dans la première couche (1), on réalise des accidents (11) dans le cristal pour que la diffusion se fasse plus rapidement dans les zones accidentées (11) que dans les zones non accidentées.

5. Procédé selon la revendication 4,
caractérisé en ce que
les accidents du cristal sont réalisés par usinage mécanique, implantation de particules de corps étrangers ou application d'un rayonnement.

6. Procédé selon la revendication 4 ou 5,
caractérisé en ce que
la première couche de silicium (1) a une concentration en dopant essentiellement régulière.
